# EUROPÄISCHE PATENTSCHRIFT

(11) **EP 2 286 981 B1**
(45) Veröffentlichungstag und Bekanntmachung des Hinweises auf die Patenterteilung: **12.12.2012**
(21) Anmeldenummer: 09010780.6
(22) Anmeldetag: 22.08.2009
(51) Int. Cl.: B29C 59/02, G03F 7/00

(54) **Verfahren zum Heissprägen einer Polymerschicht**
Process for heat embossing a polymer layer
Procédé destiné à l'imprégnation à chaud d'une couche de polymère

(43) Veröffentlichungstag der Anmeldung: 23.02.2011
(60) Teilanmeldung: 12177590.2
(73) Patentinhaber: EV Group E. Thallner GmbH, 4782 St. Florian (AT)
(72) Erfinder: Kast, Michael, DI Dr., 4600 Wels (AT)
(74) Vertreter: Schweiger, Johannes

(56) Entgegenhaltungen:
- EP-A1- 1 316 402
- WO-A1-00/18591
- WO-A1-03/099536
- DE-A1-102006 004 644
- US-A1- 2003 234 470
- US-A1- 2009 061 152
- US-B2- 6 764 737

## Beschreibung

Die Erfindung betrifft ein Verfahren zum Heißprägen einer Polymerschicht gemäß Anspruch 1.

In der Mikro- und Nanostrukturtechnik wird Heißprägen für die Übertragung eines mikro- oder nanoskaligen Musters in eine Polymerschicht verwendet. Dabei wird ein flächiges Substrat zunächst mit einem Polymer beschichtet und anschließend mit einem vorstrukturierten Stempel in Kontakt gebracht. Anschließend wird das Polymer erhitzt, um es zu verflüssigen. Der Stempel wird dann bei definiertem Druck in die flüssige Polymerschicht gepresst. Dabei ist es besonders wichtig, einen möglichst gleichförmigen Prägedruck über die gesamte Fläche des Substrats aufzubringen. Abschließend wird die Polymerschicht bei einer vordefinierten Temperatur vom Stempel abgeformt und auf Raumtemperatur abgekühlt.

Die US 2009/0061152 A1 zeigt ein Verfahren zur Herstellung von isolierten Micro- und Nanostrukturen mit einem Prägeverfahren. Die US 6,764,737 B1 offenbart ein Heißprägeverfahren. Die US 2003/0234470 A1 offenbart eine Prägevorrichtung und ein Prägeverfahren. Die WO-A-03/099536 zeigt ein Verfahren und eine Vorrichtung einer feld-induzierten Prägelithographie. Die WO-A-00/18591 zeigt ein Sicherheitsdokument einschließlich eines nanopartikel-basierten Authentifizierungs-Geräts.

Das Heißprägen wird unter anderem für die Herstellung von mikrooptischen Strukturen, mikrofluidischen Bauteilen sowie magnetischen Datenträgern verwendet.

Im Vergleich zu photolithographsichen Methoden ist der Durchsatz bei dem vorbeschriebenen Heißprägeverfahren insbesondere wegen der thermischen Prozesse geringer. Für den Einsatz des Heißprägeverfahrens in der industriellen Massenproduktion, beispielsweise die Herstellung von Festplatten oder Bildschirmen, wäre daher ein Bedarf für optimierte Durchsatzzeiten. Die maximale Durchsatzzeit ergibt sich aus der Summe der Abpumpzeit, Aufheizzeit, Prägezeit, Abkühlzeit, Abformzeit und Belüftungszeit.

Verschiedene Ansätze wie die Verkürzung der thermischen Zyklen, beispielsweise durch Verwendung von Polymeren mit niedriger Glasübergangstemperatur, oder die externe Kühlung des Substrats nach dem Prägeprozess haben nicht die gewünschten Effekte gezeigt oder andere Nachteile mit sich gebracht. So ist beispielsweise bei partiellem Heizen des Prägesystems aufgrund unterschiedlicher Ausdehnungen der einzelnen Komponenten eine Verzerrung bei der Strukturübertragung zu beobachten gewesen.

Es ist daher die Aufgabe der vorliegenden Erfindung, ein Verfahren zum Heißprägen einer Polymerschicht auf ein Substrat anzugeben, bei welchem der Durchsatz optimiert und der Energieeinsatz reduziert wird.

Diese Aufgabe wird mit den Merkmalen des Anspruchs 1 gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Bei angegebenen Wertebereichen sollen auch innerhalb der genannten Grenzen liegende Werte als Grenzwerte offenbart und in beliebiger Kombination beanspruchbar sein.

Der Erfindung liegt der Gedanke zugrunde, eine Vorrichtung mit einer auf das Minimum reduzierten thermischen Masse anzugeben, damit Aufheiz- und Abkühlzeiten beim Heißprägen möglichst effektiv verkürzt werden können. Hierfür ist erfindungsgemäß eine Temperaturerhöhungseinrichtung insbesondere Magnetfelderzeugungseinrichtung, vorgesehen, die spezifisch die Polymerschicht aufheizend ausgebildet ist. Dadurch wird die thermische Trägheit der erfindungsgemäßen Vorrichtung drastisch reduziert.

Nanopartikel oder nanoskalige Partikel im Sinne der vorliegenden Erfindung sind Partikel mit einer Partikelgröße von weniger als 500 nm, insbesondere weniger als 200 nm, vorzugsweise weniger als 50 nm. Magnetisch im Sinne der vorliegenden Erfindung bedeutet ferro-, ferri-, para- oder superparamagnetisch.

Die Aufgabe wird insbesondere dadurch gelöst, dass die thermische Masse der Heißprägevorrichtung auf die Masse der zu prägenden Polymerschicht reduziert wird und die Temperatur der mit magnetischen Nanopartikeln durchsetzten Polymerschicht durch Beaufschlagung der magnetischen Nanopartikel mit einem, vorzugsweise hochfrequenten, magnetischen Wechselfeld erhöht wird. Auf dieser Weise wird im Gegensatz zu herkömmlichen Heißprägemethoden nur die zu prägende Polymerschicht oder Teile der zu prägenden Polymerschicht auf die notwendige Prägetemperatur erhitzt und ein Aufheizen beziehungsweise Abkühlen der gesamten Heißprägevorrichtung entfällt. In einer vorteilhaften Ausgestaltung der Erfindung ist vorgesehen, dass die Magnetfelderzeugungseinrichtung ein, insbesondere hochfrequentes, vorzugsweise zumindest im Bereich der Polymerschicht homogenes, magnetisches Wechselfeld erzeugend ausgebildet ist. Durch das homogene magnetische Wechselfeld wird die Polymerschicht gleichmäßig erwärmt, ohne dass es zu Verzerrungen oder ungleichmäßigem Erweichen kommt.

Mit Vorteil ist eine Aufbringeinrichtung zum Aufbringen der Polymerschicht auf das Substrat, insbesondere in die Vorrichtung integriert, vorgesehen, damit die Aufbringung der Polymerschicht innerhalb der Vorrichtung erfolgen kann und dadurch der Durchsatz weiter erhöht wird. Als Substrat kommen Wafer in Frage. Die Aufbringung der Polymerschicht erfolgt im Spin-, Spray- oder Inkjet-Verfahren.

In einer weiteren vorteilhaften Ausführungsform der Erfindung ist vorgesehen, dass die Druckbeaufschlagungseinrichtung einen Druckzylinder zur definierten Druckbeaufschlagung des Prägestempels umfasst. Mit Vorteil ist eine Ausgleichsschicht zwischen dem Druckzylinder und dem Prägestempel und/oder zwischen dem Substrat und der Aufnahmeeinrichtung vorgesehen. Statt eines Druckzylinders kann auch eine Membran oder eine Kombination aus Druckzylinder und Membran vorgesehen sein.

Mit Vorteil ist darüber hinaus eine, insbesondere berührungsfrei arbeitende Temperaturmesseinrichtung zur Messung der Temperatur der Polymerschicht vorgesehen. Diese kann zur optimalen Prozesssteuerung durch eine entsprechende Steuerungseinrichtung verwendet werden. Um ein optimales und gleichmäßiges Magnetfeld zu erzeugen, sind der Prägestempel und/oder das Substrat nichtleitend ausgebildet, so dass die Magnetfelderzeugungseinrichtung unterhalb und/oder oberhalb der Polymerschicht angeordnet sein kann und ein über die Fläche der Polymerschicht in homogener Weise verteiltes Magnetfeld erzeugen kann.

Soweit die Vorrichtung die Polymerschicht intrinsisch aufheizend ausgebildet ist, wird ein Minimum an Energie für die Aufheizung der Polymerschicht verwendet. Dies wird insbesondere dadurch erreicht, dass die Bauteile der Vorrichtung aus Materialien bestehen, die auf das magnetische Wechselfeld nicht ansprechen.

Bei dem erfindungsgemäßen Verfahren zum Heißprägen einer magnetischen Nanopartikel enthaltenden Polymerschicht, insbesondere auf ein Substrat wird zunächst, insbesondere durch einen Roboterarm, das Polymer oder das mit der Polymerschicht zu beschichtende Substrat in die Vorrichtung eingebracht, und zwar auf die Substrataufnahme. Anschließend wird zur Vermeidung von Lufteinschlüssen in der Polymerschicht ein Vakuum im Prägeraum angelegt. Im Anschluss daran und/oder während des Vakuumanlegens wird die Polymerschicht mit der Magnetfelderzeugungseinrichtung aufgeheizt, indem durch das möglichst homogene Magnetfeld die in der Polymerschicht möglichst homogen verteilten magnetischen Nanopartikeln aufgeheizt werden. Bei dem Magnetfeld handelt es sich um ein hochfrequentes magnetisches Wechselfeld. Das Substrat selbst kann durch die Polymerschicht gebildet sein, insbesondere wenn das Prägen von beiden Seiten der Polymerschicht erfolgt.

Nach Erweichen der Polymerschicht, insbesondere erfasst durch eine Temperaturmesseinrichtung zur Messung der Temperatur der Polymerschicht, erfolgt die Druckbeaufschlagung der aufgeheizten Polymerschicht mit dem Prägestempel, und zwar durch eine Druckbeaufschlagungseinrichtung, insbesondere bestehend aus einem den Prägestempel aufnehmenden Druckzylinder. Die Druckbeaufschlagungseinrichtung kann auch auf das Substrat wirkend ausgebildet sein.

Das Erweichen der Polymerschicht ist abhängig vom Material beziehungsweise von der Materialzusammensetzung der Polymerschicht und das Erweichen beginnt mit der Glasübergangstemperatur. Die Druckbeaufschlagung beginnt demnach mit Vorteil bei einer Temperatur oberhalb der Glasübergangstemperatur.

Nach erfolgter Druckbeaufschlagung wird die Polymerschicht abgekühlt, was durch die mit Vorteil intrinsisch erfolgte Aufheizung innerhalb kürzester Zeit geschieht, da die anderen Bauteile der Vorrichtung nicht oder nur unwesentlich aufgeheizt wurden. Unterhalb der Erweichungstemperatur der Polymerschicht wird der Prägestempel von der zumindest teilweise ausgehärteten Polymerschicht getrennt.

Die Druckbeaufschlagungseinrichtung kann auch von beiden Seiten der Polymerschicht oder auf zwei Polymerschichten wirkend ausgebildet sein. Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in:
- Fig. 1:: Eine schematische Darstellung einer erfindungsgemäßen Vorrichtung in einer ersten Ausführungsform und
- Fig. 2:: eine schematische Darstellung einer erfindungsgemäßen Vorrichtung in einer zweiten Ausführungsform.

In den Figuren sind gleiche Bauteile und Bauteile mit der gleichen Funktion mit den gleichen Bezugszeichen gekennzeichnet.

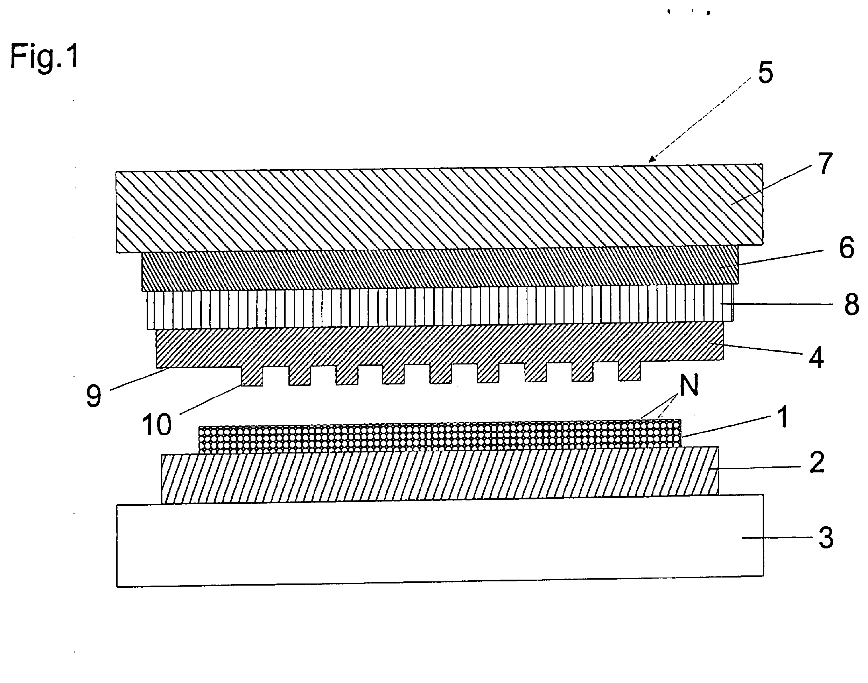

In Figur 1 ist ein mit einer Polymerschicht 1 zu versehendes Substrat 2 auf einer Substrataufnahme 3 gezeigt. Die Substrataufnahme 3 kann ein Chuck sein und das Substrat 2 wird auf die Substrataufnahme 3 durch einen nicht dargestellten Roboterarm aufgebracht und nach Aufbringung der Polymerschicht 1 wieder entladen.

Die Polymerschicht 1 enthält magnetische Nanopartikel N, die möglichst homogen in der Polymerschicht 1 verteilt sind.

Die Einbringung oder Aufbringung der Polymerschicht 1 erfolgt beispielsweise durch Spin-Belacken, Laminieren oder Verbinden mit dem Substrat während des Prägens oder durch Inkjet-Verfahren.

Gegenüberliegend zu der Substrataufnahme 3 ist eine Druckbeaufschlagungseinrichtung 5 an der Vorrichtung fixiert und die Druckbeaufschlagungseinrichtung 5 weist einen Druckzylinder 7 auf, der einen am Druckzylinder 7 angebrachten Prägestempel 4 in Richtung des Substrats 2 verschieben kann. Der Prägestempel 4 und das Substrat 2 sind dabei fluchtend und parallel zueinander ausgerichtet beziehungsweise ausrichtbar.

Zwischen dem Prägestempel 4 und dem Druckzylinder 7 ist eine Ausgleichsschicht 8 und eine Magnetfelderzeugungseinrichtung 6 vorgesehen, die im Ausführungsbeispiel als Magnetspule ausgebildet ist.

Damit im Ausführungsbeispiel gemäß Figur 1 ein homogenes Magnetfeld an der Polymerschicht 1 anlegbar ist, sind die zwischen der Magnetfelderzeugungseinrichtung 6 und der Polymerschicht 4 angeordneten Bestandteile der Vorrichtung, hier Ausgleichsschicht 8 und Prägestempel 4 nichtleitend ausgebildet.

Die Magnetspule kann ebenso unterhalb des Substrats 2 angeordnet sein, wobei dann das Substrat 2 nichtleitend ausgebildet sein muss.

Die Ausgleichsschicht 8 kann ebenfalls unterhalb des Substrats 2 angeordnet sein, um die Funktion einer homogenen Druckverteilung über die Fläche des Substrats 2 zu gewährleisten.

Alternativ kann die Ausgleichsschicht 8 fluidisch, insbesondere isostatisch wirkend, ausgebildet sein.

Der Druckzylinder 7 kann statt auf den Prägestempel 4 auch auf die Substrataufnahme 3 und damit das Substrat 2 wirkend ausgebildet sein, wobei in diesem Fall der Prägestempel 4 durch einen Stempelhalter fixiert gehalten wird.

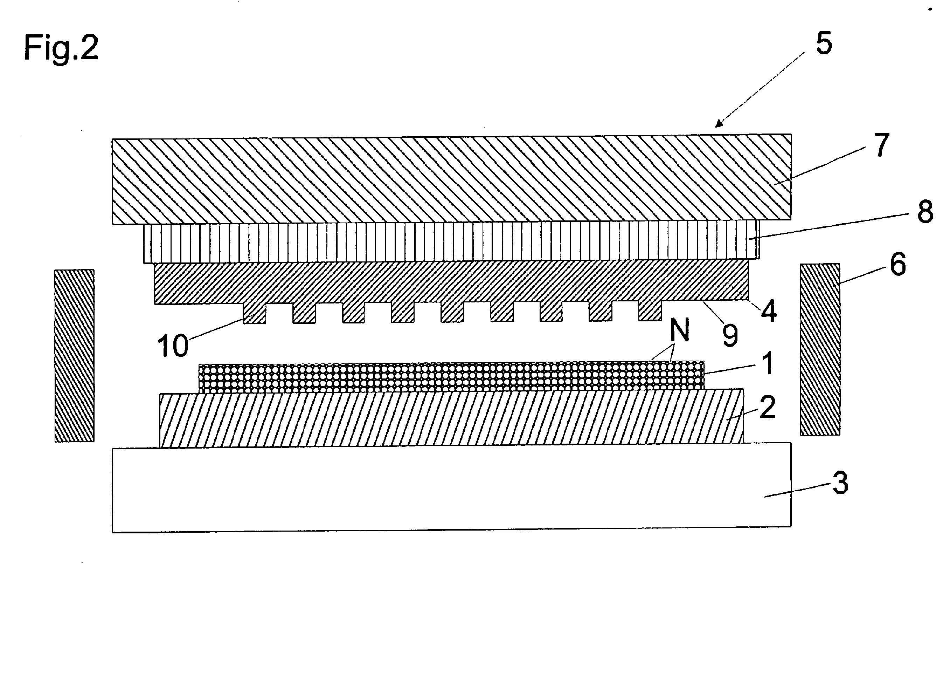

In dem in Figur 2 dargestellten Ausführungsbeispiel der vorliegenden Erfindung ist die Magnetfelderzeugungseinrichtung 6 seitlich von der Polymerschicht 1, insbesondere die Polymerschicht 1 ringförmig umschließend, angeordnet. Bei dieser Ausführungsform können ein beliebiger Prägestempel 4 und ein beliebiges Substrat 2 verwendet werden.

Bei der Druckbeaufschlagung der aufgeheizten Polymerschicht 1 mit dem Prägestempel 4 durch den Druckzylinder 7 wird eine an einer Prägeseite 9 des Prägestempels 4 vorgesehene Prägestruktur 10 in die Polymerschicht 1 geprägt.

### Bezugszeichenliste

- 1: Polymerschicht
- 2: Substrat
- 3: Substrataufnahme
- 4: Prägestempel
- 5: Druckbeaufschlagungseinrichtung
- 6: Magnetfelderzeugungseinrichtung
- 7: Druckzylinder
- 8: Ausgleichsschicht
- 9: Prägeseite
- 10: Prägestrucktur
- N: Nanopartikel

## Patentansprüche

1. Verfahren zum Heißprägen einer magnetische Nanopartikel enthaltenden Polymerschicht auf einem flächigen Substrat mit folgenden Schritten:
- Aufheizen der Polymerschicht mit einer ein Magnetfeld zur Anregung der magnetischen Nanopartikel erzeugenden Magnetfelderzeugungseinrichtung,
- Druckbeaufschlagung der aufgeheizten Polymerschicht mit einem Prägestempel durch eine Druckbeaufschlagungseinrichtung,
- Abkühlen der geprägten Polymerschicht,
- Trennen des Prägestempels von der zumindest teilweise ausgehärteten, abgekühlten Polymerschicht.

2. Verfahren nach Anspruch 1,
**dadurch gekennzeichnet,**
**dass** das Aufheizen der Polymerschicht intrinsisch erfolgt.

3. Verfahren nach Anspruch 1,
**dadurch gekennzeichnet,**
**dass** die Magnetfelderzeugungseinrichtung beim Aufheizen ein, insbesondere hochfrequentes, vorzugsweise zumindest im Bereich der Polymerschicht homogenes, magnetisches Wechselfeld erzeugt.

4. Verfahren nach einem der vorhergehenden Ansprüche,
**dadurch gekennzeichnet,**
**dass** eine, insbesondere fluidisch, vorzugsweise isostatisch, wirkende, Ausgleichsschicht (8) zur homogenen Druckverteilung beim Prägen vorgesehen ist.

## Claims

1. Method for hot embossing of a magnetic nanoparticle- containing polymer layer on a planar substrate with the following steps:
- heating the polymer layer with a magnetic field generating means which generates a magnetic field for excitation of the magnetic nanoparticles,
- application of pressure to the heated polymer layer with an embossing die by a pressure application means,
- cooling of the embossed polymer layer,
- separation of the embossing die from the at least partially set, cooled polymer layer.

2. Method as claimed in Claim 1, wherein the heating of the polymer layer takes place intrinsically.

3. Method as claimed in Claim 1, wherein the magnetic field generating means generates an especially high frequency alternating magnetic field which is homogeneous preferably at least in the region of the polymer layer.

4. Method as claimed in one of the preceding claims, wherein there is a compensation layer (8) which acts especially in a fluid manner, preferably isostatically, for homogeneous pressure distribution during embossing.

## Revendications

1. Procédé destiné au marquage à chaud d'une couche de polymère qui contient des nanoparticules magnétiques et qui est située sur un substrat plan, comportant les étapes suivantes :
- chauffage de ladite couche de polymère au moyen d'un dispositif générateur d'un champ magnétique qui génère un champ magnétique destiné à exciter lesdites nanoparticules magnétiques,
- application d'une pression à la couche de polymère chauffée au moyen d'un dispositif d'application de pression mettant en oeuvre un poinçon de marquage,
- refroidissement de la couche de polymère marquée,
- séparation du poinçon de marquage de la couche de polymère refroidie qui est au moins partiellement durcie.

2. Procédé selon la revendication 1,
**caractérisé en ce que**
ledit chauffage de la couche de polymère est réalisé de manière intrinsèque.

3. Procédé selon la revendication 1,
**caractérisé en ce que**
ledit dispositif générateur d'un champ magnétique génère un champ magnétique alternatif qui est préférentiellement homogène, au moins au niveau de ladite couche de polymère, et qui présente notamment une haute fréquence.

4. Procédé selon l'une des revendications précédentes,
**caractérisé en ce que**
l'on met en oeuvre une couche d'amortissement (8), fonctionnement notamment au moyen de fluides et ayant de préférence en effet isostatique, pour obtenir une répartition homogène de la pression lors du marquage.
